# EUROPÄISCHE PATENTSCHRIFT

(11) **EP 0 927 400 B1**
(45) Veröffentlichungstag und Bekanntmachung des Hinweises auf die Patenterteilung: **08.03.2000**
(21) Anmeldenummer: 97909149.3
(22) Anmeldetag: 18.09.1997
(51) Int. Cl.: G06F 17/50

(54) **VERFAHREN ZUR OPTIMIERTEN PLAZIERUNG TECHNISCHER KOMPONENTEN IN EINER VORGEBBAREN TOPOLOGIE, DURCH EINEN RECHNER**
COMPUTER-AIDED METHOD FOR OPTIMIZED ARRANGEMENT OF TECHNICAL COMPONENTS IN A TOPOLOGY TO BE DEFINED IN ADVANCE
TECHNIQUE D'OPTIMISATION PAR ORDINATEUR DU PLACEMENT DE COMPOSANTS TECHNIQUES DANS UNE TOPOLOGIE A DEFINIR D'AVANCE

(30) Priorität: 18.09.1996 DE 19638130
(43) Veröffentlichungstag der Anmeldung: 07.07.1999
(73) Patentinhaber: SIEMENS AKTIENGESELLSCHAFT, 80333 München (DE)
(72) Erfinder: LAUTHER, Ulrich, D-80686 München (DE); HOFMEISTER, Michael, D-84405 Dorfen (DE)
(86) Internationale Anmeldenummer: DE9702110
(87) Internationale Veröffentlichungsnummer: WO9812654

(56) Entgegenhaltungen:
- WO-A-90/03618
- FREIER B E: "REDUCING THE PHYSICAL DESIGN CYCLE BY MEANS OF TOPOLOGICAL PLACEMENT WITH HARD TIMING RESTRAINTS" PROCEEDINGS OF THE INTERNATIONAL SYMPOSIUM ON CIRCUITS AND SYSTEMS (ISCS), CHICAGO, MAY 3 - 6, 1993, Bd. 3 OF 4, 3.Mai 1993, INSTITUTE OF ELECTRICAL AND ELECTRONICS ENGINEERS, Seiten 2063-2066, XP000390103
- MASSOUD PEDRAM ET AL: "A HIERARCHICAL FLOORPLANNING APPROACH" PROCEEDINGS OF THE INTERNATIONAL CONFERENCE ON COMPUTER DESIGN: VLS IN COMPUTERS AND PROCESSORS, CAMBRIDGE, MA., SEPT. 17 - 19, 1990, Nr. -, 17.September 1990, INSTITUTE OF ELECTRICAL AND ELECTRONICS ENGINEERS, Seiten 332-338, XP000201639

## Beschreibung

Beispielsweise bei der Planung und der Verlegung von terrestrischen Kommunikationsnetzen, z. B. von terrestrischen Televisionsnetzen, werden ausgehend von einer vorgegebenen Topologie, beispielsweise einem Stadtplan oder einem Plan über einen möglichen Verlauf des Netzes, verschiedenste technische Komponenten unter Berücksichtigung der für die Verlegung bzw. für den Betrieb erforderlichen Kosten verplant bzw. verlegt.

Üblicherweise werden die Netze von Experten ohne Unterstützung eines Rechners geplant und entsprechend der Planung verlegt.

Dies erfordert jedoch einen sehr hohen Bedarf an Know-how der Personen, die die Planung und die Verlegung durchführen sollen. Dies bedeutet, daß diese Verfahren nur von hochspezialisierten Experten auf dem jeweiligen technischen Gebiet vorgenommen werden können. Des weiteren sind die Ergebnisse dieser Verfahren im allgemeinen nicht optimal und erfordern einen erheblichen Zeitaufwand zur Durchführung des Verfahrens.

In FREIER B E: "REDUCING THE PHYSICAL DESIGN CYCLE BY MEANS OF TOPOLOGICAL PLACEMENT WITH HARD TIMING CONSTRAINTS"; Proc. of the Int. Symposium on Circuits and Systems; Chicago, May 3-6, 1993; IEEE, Seiten 2063-2066 wird ein Plazierungs-Verfahren für Integrierte Schaltungen gezeigt, bei dem die Layout-Oberfläche in topologische Ringe aufgeteilt wird, um so vorgegebene Signallaufzeiten zu berücksichtigen.

Der Erfindung liegt das Problem zugrunde, ein rechnergestütztes Verfahren zur vollautomatischen Plazierung technischer Komponenten in eine vorgebbare Topologie unter Einhaltung von Restriktionen anzugeben.

Das Problem wird durch das Verfahren gemäß Patentanspruch 1 gelöst.

Das Verfahren wird mit einem Rechner durchgeführt, dem eine vorgebbare Topologie möglicher Plazierungen und Kopplungen der technischen Komponenten beispielsweise in Form eines digitalen Stadtplans zugeführt wird. Die Topologie weist eine z. B. baumförmige Struktur mit einer beliebigen Anzahl von Knoten und Kanten auf. Unter einer baumförmigen Struktur ist in diesem Zusammenhang ein zusammenhängender Graph ohne Schleifen und Mehrfachkanten zu verstehen.

In einem ersten Schritt wird mindestens einem Teil der Knoten eine Liste von technischen Komponenten zugeordnet, die jeweils prinzipiell dem Knoten zugeordnet werden können. Die Liste wird in dem Rechner gespeichert und ein rekursives Verfahren wird ausgehend von einem Wurzelknoten auf die baumförmigen Topologie angewendet. Das rekursive Verfahren wird jeweils für einen Knoten durchgeführt, der entweder direkt mit dem Wurzelknoten oder über einen zuvor schon mit dem Verfahren bearbeiteten Knoten mit dem Wurzelknoten gekoppelt sind. Es wird jeweils überprüft, ob bei Verwendung der technischen Komponenten der Liste in dem jeweiligen Knoten vorgebbare Restriktionen eingehalten werden.

Die Überprüfung wird für alle Komponenten in der Liste und für jeweils alle Nachbarknoten des aktuell untersuchten Knoten rekursiv durchgeführt. Jeweils die Komponenten werden dem Knoten zugeordnet, für den die Restriktionen eingehalten werden können.

Mit diesem Verfahren wird es erstmals möglich, eine vollautomatische optimierte Plazierung technischer Komponenten in einem Netz vorgebbarer Topologie durchzuführen. Somit ist kein Expertenwissen zur Durchführung des Verfahrens mehr erforderlich, was zu einer erheblichen Kostensenkung und Zeitersparnis bei der Durchführung des Verfahrens führt.

Weiterhin hat es sich gezeigt, daß die Ergebnisse des rechnergestützten Verfahrens erheblich besser sind als die üblich von Experten durchgeführten Verfahren.

Vorteilhafte Weiterbildungen der Erfindung ergeben sich aus den abhängigen Ansprüchen.

Die Durchführung des Verfahrens mit Hilfe eines Rechners wird dadurch erheblich beschleunigt, daß das rekursive Verfahren jeweils in einer Rekursionsschleife abgebrochen wird, wenn für einen Knoten in der dem Knoten zugeordneten Liste keine Komponente vorhanden ist, mit der die Restriktionen eingehalten werden können.

Eine weitere Beschleunigung bei der Durchführung des Verfahrens ist dadurch erreichbar, daß die Komponenten in den Knoten in abfallender Reihenfolge bezüglich eines vorgebbaren Optimierungskriteriums überprüft werden und jeweils nur die Komponente weiter berücksichtigt wird, mit der in dieser Reihenfolge zuerst die Restriktion eingehalten wird.

Ein Ausführungsbeispiel der Erfindung ist in den Figuren dargestellt und wird im weiteren näher erläutert.

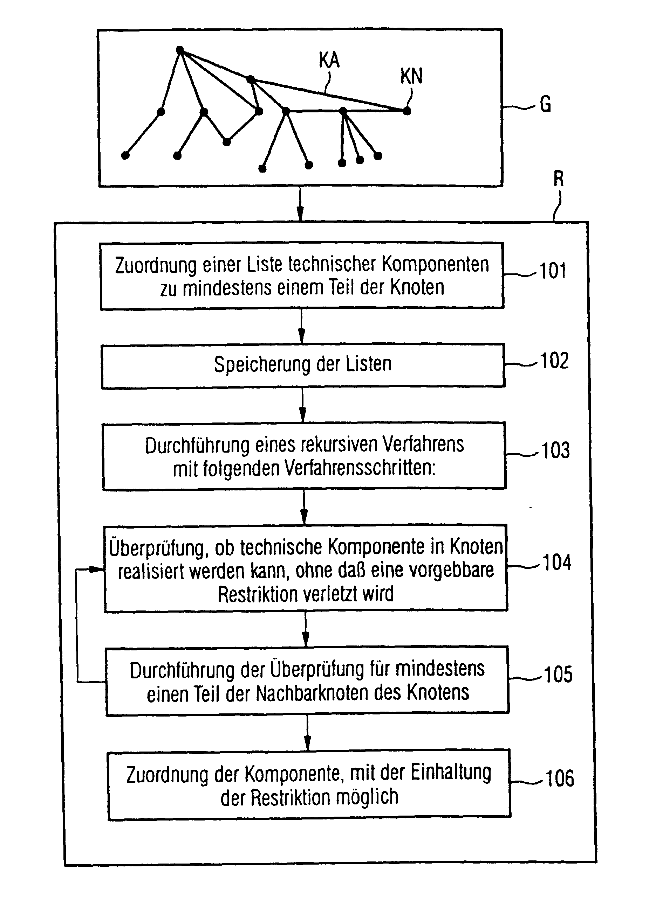

Es zeigt
- Fig. 1: Ein Ablaufdiagramm, in dem das Verfahren mit seinen Verfahrensschritten beschrieben ist.

In Fig. 1 ist das Verfahren in Form eines Ablaufdiagramms skizziert. Bei dem Verfahren wird einem Rechner R, mit dem das Verfahren durchgeführt wird, eine vorgebbare Topologie mit vorzugsweiser baumförmiger Struktur mit einer beliebigen Anzahl von Knoten KN und Kanten KA zugeführt. Die vorgebbare Topologie wird im weiteren als Graph G bezeichnet.

Mit der Topologie, die in digitaler Form vorliegt, werden beispielsweise mit den Knoten KN Punkte für die mögliche Plazierung technischer Komponenten in dem durch die Topologie vorgegebenen möglichen Netz beschrieben. Einer der Knoten KN repräsentiert z. B. einen Einspeisungspunkt E in das Netz. Endknoten der baumförmigen Struktur sind beispielsweise Bedarfspunkte, die über das Netz mit dem Einspeisungspunkt E verbunden werden sollen.

Weiterhin sind in der Topologie Kanten KA enthalten, mit denen die einzelnen möglichen Plazierungspunkte, d. h. die Knoten KN, gekoppelt sind. Mit den Kanten KA werden mögliche Verbindungen der einzelnen Plazierungspunkte, der Knoten KN, beschrieben. Insgesamt beschreibt die baumförmige Topologie, der Graph G, beispielsweise bei Verlegung von terrestrischen Televisionsnetzen eine Topologie von Gräben, in denen das Televisionsnetz, allgemein ein elektrisches Netz, realisiert werden soll.

Ziel des Verfahrens ist es, eine kostenoptimierte Plazierung und Verdrahtung, also Kopplung technischer Komponenten in der vorgegebenen Topologie zu ermitteln, so daß jeder Knoten unter Einhaltung mindestens einer vorgebbaren Restriktion versorgt wird.

In einer Weiterbildung des Verfahrens werden als technische Komponenten elektrische Komponenten und zur Kopplung der elektrischen Komponenten elektrische Kopplungen, beispielsweise Kabel verwendet.

Bei einer im weiteren beschriebenen Verwendung des Verfahrens zur kostenoptimierten Planung und Verlegung von terrestrischen Televisionsnetzen können als elektrische Komponenten beispielsweise eine Auswahl der folgenden technischen Komponenten zur Plazierung verwendet werden.
- Sog. Fiber Nodes,
   wobei die Fiber Nodes beispielsweise über Glasfaserkabel miteinander verbunden werden,
- sog. Linienverstärker,
- sog. Verteilverstärker,
- sog. Abzweiger.

Die elektrischen Komponenten führen zu unterschiedlichen Kosten, die in der Plazierung optimiert werden sollen.

Ein Problem bei der Plazierung der unterschiedlichen elektrischen Komponenten ist darin zu sehen, daß die verschiedenen Komponenten unterschiedlichen Restriktionen unterliegen, die beispielsweise in der folgenden Übersicht dargestellt sind:
- Ein Einspeisungspunkt, der im weiteren als Wurzelknoten WKN des Graphen G bezeichnet wird, besteht aus einem Fiber Node. Der Fiber Node hat üblicherweise zwei Ausgänge, über die jeweils ein Signalpegel von 98dB bzw. 100dB über die gesamte Frequenzbreite zur Verfügung gestellt wird.
- Vorgegebene Bedarfspunkte, die Knoten KN, denen beispielsweise Bedarfszahlen zugeordnet werden, werden durch das realisierte Kabelnetz entlang der Kanten KA des Graphen G versorgt.
- An jedem Bedarfspunkt wird ein Verteilverstärker beispielsweise des Typs VGF11 installiert, von dem aus z. B. eine In-House-Verteilung des Televisionssignals vorgenommen werden kann.
- Zur Verzweigung eines Kabels stehen verschiedene passive Elemente zur Verfügung.
- Das Kabel hat ein frequenzabhängiges, die passiven Komponenten ein frequenzunabhängiges Dämpfungsverhalten. Durch die frequenzabhängige Dämpfung entsteht eine sog. Schräglage.
- Zum Ausgleich der Dämpfung und der Schräglage stehen sog. Linienverstärker des Typs VGF10 zur Verfügung.
- Alle Verstärker haben minimale/maximale Eingangssignalpegel und Ausgangssignalpegel und einen innerhalb gewisser Grenzen frei skalierbaren Verstärkungsbereich.
- Am Eingang eines jeden Verstärkers darf max. 10dB Schieflage auftreten. Dieser Betrag kann durch die Verstärker ausgeglichen werden.
- Entlang eines jeden Pfades von dem Wurzelknoten WKN (dem Fiber Node) zu einem Verteilverstärker dürfen höchstens zwei Linienverstärker plaziert sein.
- An den Ausgängen der Verteilerverstärker muß ein Pegel von 100dB anliegen.

In der folgenden Tabelle ist beispielhaft eine Übersicht über möglicherweise zu verwendende elektrische Komponenten bei der Plazierung dargestellt:

| Komponente | Eingänge | Ausgänge | Dämpfung | Schräglage | Verstärkung | Kosten |
|---|---|---|---|---|---|---|
| Linienverstärker | 1x64/90d | 2x74/100 dB | keine | max.10dB | 10-28dB | 830,-DM |
| Verteilverstärker | 1x70/88 dB | 2x82/100 dB | keine | max.10dB | 12-30dB | 520,-DM |
| ORA800 | | 2x100dB | | | | 4500,-DM |
| | | lx94dB | | | | |
| Verteiler1 | 1 | 2 | je 3,7dB | keine | keine | 50,-DM |
| Verteiler2 | 1 | 3 | je 5,0dB | keine | keine | 50,-DM |
| Abzweiger1 | 1 | 2 | 2.0/8.5 dB | keine | keine | 50,-DM |
| Abzweiger2 | 1 | 2 | 1.6/12.0 dB | keine | keine | 50,-DM |
| Abzwei3 | 1 | 2 | 1.3/13.0 dB | keine | keine | 50,-DM |
| Kabel | | | 2dB/100m (86MHz) 6dB/100m (862MHz) | | | 1,57DM / 100m |

Das Verfahren kann jedoch für alle anderen Arten von technischen Komponenten ebenso durchgeführt werden. Dieses Beispiel dient lediglich zur besseren Darstellbarkeit der Erfindung.

Dies gilt ebenso für die mindestens eine Restriktion, da allgemein jede beliebige, abhängig von der Anwendung des Verfahrens vorgebbare, vorzugsweise komponentenbezogene Restriktion im Rahmen des Verfahrens berücksichtigt werden kann.

In einem ersten Schritt des Verfahrens 101 wird mindestens einem Teil der Knoten KN, vorzugsweise jedem Knoten KN, eine Liste technischer Komponenten zugeordnet, die an dem Knoten KN realisiert werden dürfen.

Ferner wird in einer Weiterbildung des Verfahrens jedem Knoten KN zusammen mit den Komponenten Funktionen für die jeweiligen Komponenten zugeordnet, mit denen das Verhalten der Komponenten modelliert wird.

Weiterhin ist es in einer Weiterbildung vorgesehen, daß in der Liste eine Dummy-Komponente enthalten ist, die verwendet werden kann, falls in dem Knoten KN keine Komponente errichtet werden soll.

Falls die technischen Komponenten beispielsweise asymmetrisches Verhalten bezüglich ihrer Ausgänge aufweisen, so ist es vorteilhaft, die Komponenten gemäß der möglichen Permutationen der Ausgänge in den Listen mehrfach aufzuführen.

### Beispiel für eine Modellierungsfunktion

Die Listen, die jeweils den Knoten KN zugeordnet werden wurden, werden in einem zweiten Schritt 102 gespeichert.

Ausgehend von dem Wurzelknoten WKN der baumförmigen Topologie, beispielsweise ausgehend von dem Fiber Node, wird folgendes rekursive Verfahren durchgeführt 103:

Für jeden Knoten KN, der entweder direkt mit dem Wurzelknoten WKN gekoppelt ist oder über Knoten KN mit dem Wurzelknoten WKN gekoppelt ist, die mit dem Verfahren schon bearbeitet wurden, wird überprüft, ob eine technische Komponente vom Komponententyp K, der jeweils in der Liste eingetragen ist, unter Einhaltung der vorgebbaren Restriktion in den Knoten KN gesetzt werden kann oder nicht 104.

Dabei wird, wie oben beschrieben wurde, angenommen, daß alle Knoten KN entlang des Pfades von dem Einspeisungspunkt bis zu dem aktuell untersuchten Knoten KN bereits mit Komponenten bestückt sind.

Für mindestens einen Teil von Nachbarknoten NKN des aktuell bearbeiteten Knotens KN, vorzugsweise für alle Nachbarknoten NKN wird der oben beschriebene Verfahrensschritt der Überprüfung der Komponenten der Liste der Nachbarknoten NKN unter Einhaltung der einen oder mehreren Restriktionen durchgeführt 105.

Es wird jeweils die Komponente des Typs dem Knoten zugeordnet, für den sich ergeben hat, daß der Typ der Komponente dem Knoten KN zugeordnet werden kann unter Einhaltung der Restriktionen 106.

In einer Weiterbildung des Verfahrens ist es vorgesehen, daß eine Restriktionsschleife dann beendet wird, falls für einen Knoten KN innerhalb der Rekursionsschleife keine Komponente ermittelt werden konnte, mit der die eine oder mehrere Restriktionen eingehalten werden kann bzw. können. Durch diese Weiterbildung wird die Durchführung des Verfahrens mit Hilfe eines Rechners R erheblich beschleunigt.

Ferner ist es in einer Weiterbildung des Verfahrens vorgesehen, die Komponenten in den Knoten KN jeweils in abfallender Reihenfolge bezüglich eines Optimierungskriteriums zu überprüfen.

Dies kann beispielsweise dadurch erfolgen, daß die Komponenten zu Beginn des Verfahrens in der entsprechenden Reihenfolge in der Liste gespeichert werden, und jeweils das erste Element der Liste entnommen und überprüft wird.

Ferner ist es in einer Weiterbildung des Verfahrens vorgesehen, daß jeweils nur solange Komponenten in einer Liste überprüft werden, bis eine erste Komponente ermittelt wurde, mit der die Restriktion eingehalten werden konnte.

Bei der Anwendung des Verfahrens auf terrestrische Televisionsnetze ist beispielsweise das Optimierungskriterium durch eine Summe der Kosten der einzelnen Komponenten und des Kabels gegeben.

Dies bedeutet, daß zu jedem Knoten KN der mindestens erforderliche Eingangssignalpegel ermittelt wird. Bei sog. Blattknoten, die sich am Ende der baumförmigen Topologie befinden und die in diesem Anwendungsfall den sog. In-House-Verstärkern entsprechen, ist dieser Wert konstant und bekannt.

Bei inneren Knoten der Topologie ergibt sich der Wert des Eingangssignalpegels, der im weiteren als Mindestsignalpegel bezeichnet wird, aus
- den Mindestsignalpegeln der unmittelbar folgenden Knoten KN,
- der Dämpfung der ausgehenden elektrischen Kopplungen bezüglich der elektrischen Komponente, und
- dem Dämpfungsverhalten der in dem Knoten KN verwendeten elektrischen Komponente.

Es wird z. B. für jeden Knoten KN jeder zulässige Komponententyp K versuchsweise eingesetzt und schließlich derjenige Komponententyp K als erster Komponententyp K der Liste ausgewählt, der am Eingang den niedrigsten Mindestsignalpegelwert ergibt. Der erste Komponententyp K wird an die erste Stelle der Liste umsortiert.

Im folgenden wird in Form eines Pseudocodes das Verfahren mit einigen Weiterbildungen beschrieben:

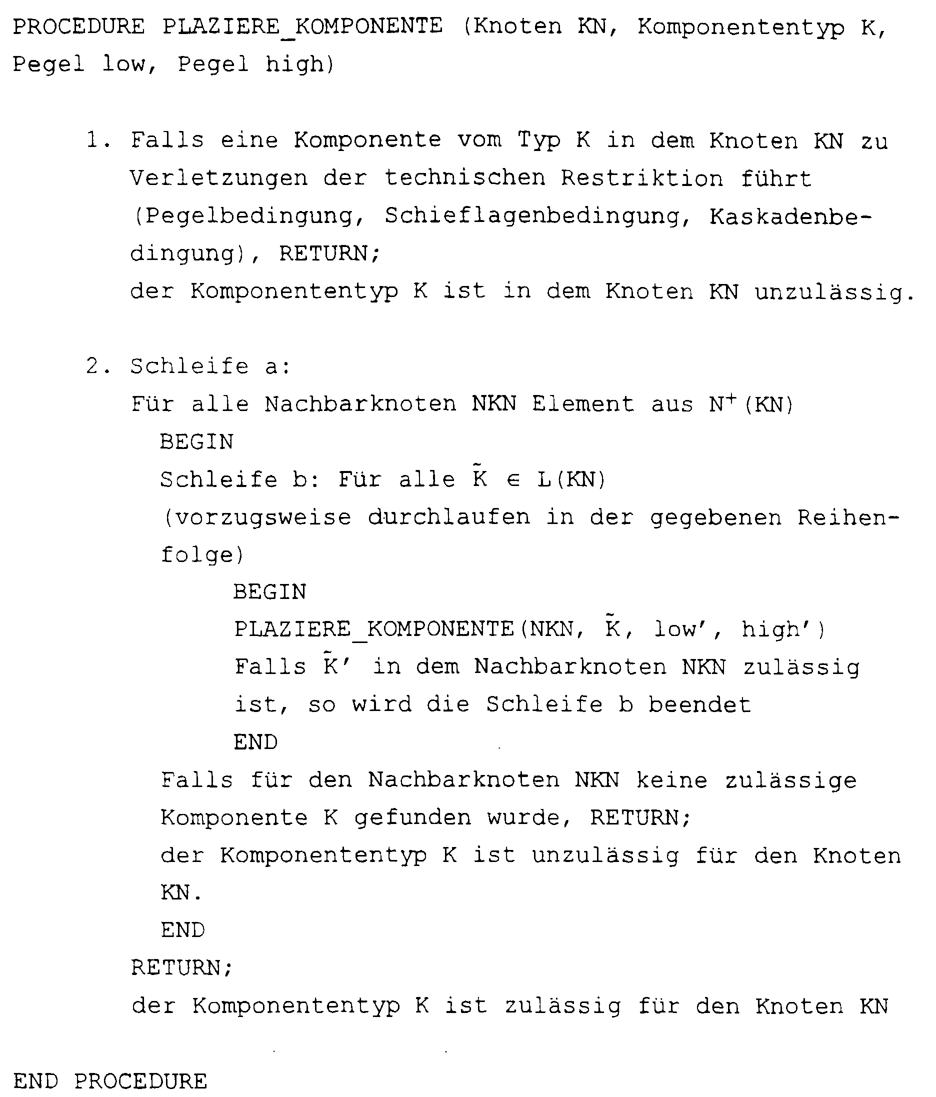

Das gesamte Verfahren wird nun ausgehend von dem Wurzelknoten WKN gemäß folgender Schleife durchgeführt:

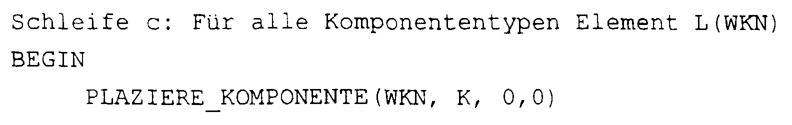

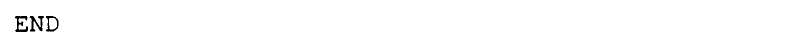

Bei der Anwendung des Verfahrens auf die Verlegung terrestrischer Televisionsnetze werden beispielsweise Linienverstärker so weit weg wie möglich von dem Einspeisungspunkt, d. h. dem Wurzelknoten WKN positioniert. Damit wird gewährleistet, daß die Kaskadenbedingung berücksichtigt wird. Dies kann zu suboptimalen Gesamtlösungen bezüglich der Anzahl der Linienverstärker führen.

Aus diesem Grund ist es in einer Weiterbildung vorgesehen, die Gesamtzahl der Linienverstärker, allgemein die Gesamtzahl einer Komponente eines vorgebbaren Typs in der Plazierung zu reduzieren.

Dies wird beispielsweise durch folgendes Verfahren erreicht:
- Es wird für mindestens ein Knotenpaar (KN1, KN2) von einem ersten Knoten KN1 und einem zweiten Knoten KN2 ermittelt, denen jeweils eine Komponente des zu reduzierenden Typs zugeordnet wurden. Das Knotenpaar (KN1, KN2) wird in einer Optimierungsliste OL gespeichert und zwar genau dann, wenn
- ein lokaler Wurzelknoten LWKN der Knoten KN1, KN2 des Knotenpaars (KN1, KN2) der Wurzelknoten WKN ist, oder
- dem lokalen Wurzelknoten LWKN der Knoten KN1, KN2 des Knotenpaars (KN1, KN2) eine Komponente des zu reduzierenden Typs zugeordnet wurde.

Unter einem lokalen Wurzelknoten LWKN ist derjenige vom Wurzelknoten WKN aus gesehen letzte Knoten KN zu verstehen, der sowohl in dem Pfad (Wurzelknoten WKN bis erster Knoten KN1) als auch in dem Pfad (Wurzelknoten WKN bis zweiter Knoten KN2) enthalten ist.

Das oben beschriebene rekursive Plazierungsverfahren wird dann erneut durchgeführt, wenn das Knotentupel (KN1, KN2) nicht in der Optimierungsliste OL gespeichert wird. Mit der Durchführung des Plazierungsverfahrens wird eine zweite Plazierung ermittelt. Die zweite Plazierung wird dann als optimierte Plazierung verwendet, falls die zweite Plazierung weniger Komponenten des zu reduzierenden Typs enthält als die ursprünglich ermittelte Plazierung.

Im folgenden wird dieses Verfahren in Form eines Pseudocodes beschrieben:
1. Sei die Optimierungsliste OL eine leere Liste, wobei die Optimierungsliste Paare von Knoten enthält, auf denen Komponenten des zu reduzierenden Typs plaziert sind.
2. Falls alle Knotenpaare (KN1, KN2) von Knoten KN, auf denen Komponenten des zu reduzierenden Typs plaziert sind, in der Optimierungsliste OL enthalten sind, STOP; das Verfahren kann keine Verbesserung finden. Ansonsten sei Knotenpaar (KN1, KN2) nicht Element der Optimierungsliste OL ein solches Paar und w = lokaler Wurzelknoten LWKN des Knotenpaars (KN1, KN2).
3. Falls W=WKN, speichere Knotenpaar (KN1, KN2) in Optimierungsliste OL. Ansonsten sei Komponententyp KD Komponente, die in dem lokalen Wurzelknoten LWKN plaziert ist.
4. Falls Komponententyp K von dem zu reduzierenden Typ ist, nimm Knotenpaar (KN1, KN2) in die Optimierungsliste OL auf.
   Ansonsten plaziere erneut mit PROCEDURE
   PLAZIERE_KOMPONENTE (w, VGF10, low, high) wobei low bzw. high die Signalpegel sind, die in w anliegen.
5. Falls eine durch die Prozedur PLAZIERE_KOMPONENTE neu ermittelte zweite Plazierung mit weniger Komponenten des zu reduzierenden Typs auskommt als die bisherigen Plazierungen, lösche alle Knotenpaare in der Optimierungsliste, die den ersten Knoten KN1 oder den zweiten Knoten KN2 enthalten.
   Ansonsten stelle mit der Prozedur PLAZIERE_KOMPONENTE (w, K, low, high) die alte Situation wieder her und speichere Knotentupel (KN1, KN2) in Optimierungsliste OL.
6. Fahre fort mit 2.

Die ermittelte Plazierung wird in einem letzten Schritt abgespeichert und ggf. einem Benutzer auf einem Bildschirm des Rechners R dargestellt.

Das Verfahren kann mit entsprechender unterschiedlicher Interpretation der Knoten KN und Kanten KA der Topologie sehr vorteilhaft auch zum Layout elektrischer Schaltungen verwendet werden, da es bei diesen gilt, Laufzeitrestriktionen, die beispielsweise durch vorgegebene mindest einzuhaltende Taktraten gegeben sind, einzuhalten.

## Patentansprüche

1. Verfahren zur optimierten Plazierung technischer Komponenten in einer vorgebbaren Topologie, die eine baumförmige Struktur mit einer beliebigen Anzahl von Knoten (KN) und Kanten (KA) aufweist, durch einen Rechner (R),
- bei dem mindestens einem Teil der Knoten (KN) eine Liste von technischen Komponenten zugeordnet wird, die an dem Knoten (KN) realisiert werden können (101),
- bei dem die Liste gespeichert wird (102),
- bei dem ausgehend von einem Wurzelknoten (WKN) der baumförmigen Topologie folgendes rekursives Verfahren durchgeführt wird (103):
a) es wird für mindestens einen Teil der Knoten (KN), die entweder direkt mit dem Wurzelknoten (WKN) gekoppelt sind oder über Knoten (KN), die zuvor gemäß diesem Verfahren bearbeitet wurden, überprüft, ob bei Verwendung der Komponenten der Liste in dem Knoten (KN) mindestens eine vorgebbare Restriktion eingehalten wird (104),
b) der Verfahrensschritt a) wird für mindestens einen Teil von Nachbarknoten (NKN) des jeweils bearbeiteten Knoten (KN) durchgeführt (105), und
- bei dem die Komponenten den Knoten (KN) zugeordnet werden, daß für die überprüften Knoten (KN) die Restriktion eingehalten wird (106).

2. Verfahren nach Anspruch 1,
- bei dem die technischen Komponenten elektrische Komponenten sind, und
- bei dem die Kanten (KA) durch elektrische Kopplungen zwischen den elektrischen Komponenten gegeben sind.

3. Verfahren nach Anspruch 1 oder 2,
bei dem für den Fall, daß für einen Knoten (KN) keine Komponente vorhanden ist, mit der die Restriktion eingehalten werden kann, die jeweilige Rekursionsschleife beendet wird.

4. Verfahren nach einem der Ansprüche 1 bis 3,
bei dem die Komponenten in den Knoten (KN) in abfallender Reihenfolge bezüglich eines Optimierungskriteriums überprüft werden.

5. Verfahren nach Anspruch 4,
bei dem die Komponenten zu Beginn des Verfahrens in der Reihenfolge in der Liste gespeichert werden.

6. Verfahren nach Anspruch 2 und 4 oder 2 und 5,
bei dem das Optimierungskriterium durch einen Mindestsignalpegel gegeben ist, der sich bei Verwendung der Komponenten in Nachbarknoten für einen Eingang der Komponente des Knotens (KN) für die jeweilige Komponente ergibt.

7. Verfahren nach Anspruch 6,
bei dem sich der Mindestsignalpegel aus mindestens einer der folgenden elektrischen Größen ergibt:
- dem Mindestsignalpegel von Nachbarknoten (NKN) des Knotens (KN),
- der Dämpfung von der elektrischen Komponente ausgehender elektrischer Kopplungen,
- Dämpfungsverhalten der elektrischen Komponente.

8. Verfahren nach einem der Ansprüche 1 bis 7,
bei dem nach Beendigung des Verfahrens eine Reduktion der Anzahl eines Typs einer technischen Komponente durchgeführt wird.

9. Verfahren nach Anspruch 8,
bei dem für mindestens einen Teil der Knoten (KN) folgende Verfahrensschritte durchgeführt werden:
- es wird mindestens ein Knotenpaar ermittelt denen jeweils eine Komponente des zu reduzierenden Typs zugeordnet wurden,
- das Knotenpaar wird in einer Optimierungsliste (OL) gespeichert, falls ein lokaler Wurzelknoten der Knoten des Knotenpaars der Wurzelknoten ist,
- das Knotenpaar wird in der Optimierungsliste (OL) gespeichert, falls dem lokalen Wurzelknoten der Knoten des Knotenpaars eine Komponente des zu reduzierenden Typs zugeordnet wurden,
- bei dem für den Fall, daß das Knotenpaar nicht in der Optimierungsliste (OL) gespeichert wird, das Plazierungsverfahren erneut durchgeführt wird und eine zweite Plazierung ermittelt wird,
- bei dem die zweite Plazierung als optimierte Plazierung verwendet wird, falls die zweite Plazierung weniger Komponenten des zu reduzierenden Typs enthält als die ursprüngliche Plazierung.

10. Verfahren nach Anspruch 9,
bei dem zu Beginn der Verfahrensschritte des Anspruchs 9 alle Einträge der Optimierungsliste gelöscht werden.

11. Verwendung des Verfahrens nach einem der Ansprüche 1 bis 10 zur Plazierung von elektrischen Komponenten bei Televisionsnetzen.

12. Verwendung des Verfahrens nach einem der Ansprüche 1 bis 10 zur Plazierung von elektrischen Komponenten bei einem Layout elektrischer Schaltnetze.

## Claims

1. Method for optimized placement of technical components in a prescribable topology which has a dendritic structure with an arbitrary number of nodes (KN) and edges (KA), by means of a computer (R),
- in which at least a portion of the nodes (KN) is assigned a list of technical components which can be realized (101) at the node (KN),
- in which the list is stored (102), and
- in which, starting from a root node (WKN) of the dendritic topology, the following recursive method is carried out (103):
a) for at least a portion of the nodes (KN) which are coupled to the root node (WKN) either directly or via nodes (KN) which have previously been processed in accordance with this method, a check is made as to whether at least one prescribable restriction is observed (104) in the node (KN) in the case of use of the components of the list,
b) the method step a) is carried out (105) for at least a portion of neighbouring nodes (NKN) of the respective processed node (KN), and
- in which the components are assigned to the nodes (KN) in such a way that the restriction is observed (106) for the checked nodes (KN).

2. Method according to Claim 1,
- in which the technical components are electric components, and
- in which the edges (KA) are electric couplings between the electric components.

3. Method according to Claim 1 or 2, in which the respective recursion loop is terminated for the case in which no component with which the restriction can be observed is present for a node (KN).

4. Method according to one of Claims 1 to 3, in which the components in the nodes (KN) are checked in decreasing sequence with reference to an optimization criterion.

5. Method according to Claim 4, in which the components are stored in the sequence in the list at the start of the method.

6. Method according to Claims 2 and 4 or 2 and 5, in which the optimization criterion is given by a minimum signal level which results from using the components in neighbouring nodes for an input of the component of the node (KN) for the respective component.

7. Method according to Claim 6, in which the minimum signal level is yielded from at least one of the following electric variables:
- the minimum signal level of neighbouring nodes (NKN) of the node (KN),
- the damping of the electric component of outgoing electric couplings, and
- the damping response of the electric component.

8. Method according to one of Claims 1 to 7, in which a reduction in the number of one type of a technical component is carried out after termination of the method.

9. Method according to Claim 8, in which the following method steps are carried out for at least a portion of the nodes (KN):
- at least one pair of nodes is determined to which in each case one component of the type to be reduced is assigned,
- the pair of nodes is stored in an optimization list (OL) if a local root node of the nodes of the pair of nodes is the root node,
- the pair of nodes is stored in the optimization list (OL) if a component of the type to be reduced was assigned to the local root node of the nodes of the pair of nodes,
- in which for the case when the pair of nodes is not stored in the optimization list (OL) the placement method is carried out anew and a second placement is determined, and
- in which the second placement is used as optimized placement if the second placement contains fewer components of the type to be reduced than the original placement.

10. Method according to Claim 9, in which all entries in the optimization list are cleared at the start of the method steps of Claim 9.

11. Use of the method according to one of Claims 1 to 10 for placement of electric components in television networks.

12. Use of the method according to one of Claims 1 to 10 for placement of electric components in a layout of electric switching networks.

## Revendications

1. Procédé pour le placement optimisé de composants techniques, par ordinateur (R), dans une topologie définissable d'avance, laquelle topologie présente une structure arborescente avec un nombre arbitraire de noeuds (KN) et d'arêtes (KA),
- dans lequel au moins une partie des noeuds (KN) se voit attribuer une liste de composants techniques pouvant être réalisés au noeud (KN) (101),
- dans lequel la liste est mise en mémoire (102),
- dans lequel, à partir d'un noeud de racine (WKN) de la topologie arborescente, le procédé récursif suivant est mis en oeuvre (103):
a) il est vérifié pour au moins une partie des noeuds (KN), qui sont soit couplés directement au noeud de racine (WKN) soit par l'intermédiaire de noeuds (KN) ayant été traités préalablement selon ce procédé, si lors de l'utilisation des composants de la liste dans le noeud (KN), au moins une restriction définissable d'avance est respectée (104),
b) l'étape a) du procédé est effectuée pour au moins une partie de noeuds voisins (NKN) du noeud respectif traité (105), et
- dans lequel les composants sont attribués aux noeuds (KN), de manière à respecter la restriction pour les noeuds (KN) vérifiés.

2. Procédé selon la revendication 1,
- dans lequel les composants techniques sont des composants électriques, et
- dans lequel les arêtes (KA) sont données par des couplages électriques entre les composants électriques.

3. Procédé selon la revendication 1 ou 2, dans lequel, pour le cas où il n'existe pas de composant pour un noeud (KN), permettant de respecter la restriction, la boucle de récurrence respective est arrêtée.

4. Procédé selon l'une des revendications 1 à 3, dans lequel les composants dans les noeuds (KN) sont vérifiés en ordre décroissant par rapport à un critère d'optimisation.

5. Procédé selon la revendication 4, dans lequel les composants, au début du procédé, sont stockés dans l'ordre dans la liste.

6. Procédé selon les revendications 2 et 4 ou 2 et 5, dans lequel le critère d'optimisation est donné par un niveau minimal de signal, qui est obtenu en utilisant les composants dans des noeuds voisins, pour une entrée du composant du noeud (KN) pour le composant respectif.

7. Procédé selon la revendication 6, dans lequel le niveau minimal de signal est obtenu à partir d'au moins une des grandeurs électriques suivantes :
- le niveau minimal de signal de noeuds voisins (NKN) du noeud (KN),
- l'atténuation de couplages électriques partant du composant électrique,
- le comportement d'atténuation du composant électrique.

8. Procédé selon l'une des revendications 1 à 7, dans lequel, au terme du procédé, le nombre d'un type de composant technique est réduit.

9. Procédé selon la revendication 8, dans lequel, pour au moins une partie des noeuds (KN), les étapes suivantes sont effectuées :
- au moins une paire de noeuds est déterminée, à laquelle a été attribué à chaque fois un composant du type à réduire,
- la paire de noeuds est stockée dans une liste d'optimisation (OL), si un noeud de racine local est le noeud de la paire de noeuds des noeuds de racine,
- la paire de noeuds est stockée dans la liste d'optimisation (OL), si un composant du type à réduire a été attribué au noeud de racine local des noeuds de la paire de noeuds,
- dans lequel, pour le cas où la paire de noeuds n'est pas stockée dans la liste d'optimisation (OL), le procédé de placement est répété et un second placement est déterminé,
- dans lequel le second placement est utilisé comme placement optimisé, si ledit second placement contient moins de composants du type à réduire que le placement initial.

10. Procédé selon la revendication 9, dans lequel, au début des étapes du procédé selon la revendication 9, toutes les entrées de la liste d'optimisation sont effacées.

11. Utilisation du procédé selon l'une des revendications 1 à 10 pour le placement de composants électriques dans des réseaux de télévision.

12. Utilisation du procédé selon l'une des revendications 1 à 10 pour le placement de composants électriques dans un agencement de réseaux de commutation électriques.
